# EUROPEAN PATENT APPLICATION

(11) **EP 1 744 337 A2**
(43) Date of publication of application: **17.01.2007**
(21) Application number: 06011373.5
(22) Date of filing: 01.06.2006
(51) Int. Cl.: H01H 13/703

(54) **Membrane switch**

(30) Priority: 15.07.2005 JP 2005207245
(71) Applicant: FANUC LTD, Minamitsuru-gun, Yamanashi 401-0597 (JP)
(72) Inventor: Fuchigami, Hiroshi, FANUC Dai3virakaramatsu, Minamitsuru-gun, Yamanashi, 401-0511 (JP); Yairo, Osamu, Minamitsuru-gun, Yamanashi, 401-0310 (JP)
(74) Representative: Thum, Bernhard

(57) **Abstract**

A membrane switch is formed by laminating a pair of flexible printed circuit (FPC) boards with two types of resist between them. An oil-resistant thermally adhesive resist is used in the peripheral area between the laminated FPC boards, and a resist that is not thermally adhesive is used in the central area. The thickness of these resists forms a spacer between the FPC boards

## Description

### BACKGROUND OF THE INVENTION

### 1. Field of the Invention

The present invention relates to a membrane switch used as a keyboard or the like of a machine controller.

### 2. Description of the Related Art

A membrane switch used as a keyboard or the like is formed by laminating two sheets, on which contact electrodes and wiring patterns are printed, with a spacer sandwiched between the sheets. The spacer has holes in areas corresponding to contact electrode positions. A switch is activated by pressing on the contact electrode on one sheet so that it makes contact with an opposite contact electrode on the other sheet.

When a membrane switch of this type is employed in a machine controller such as a numerical controller, it is necessary to prevent machining oil and other foreign matter discharged by the machine from penetrating into the membrane switch. A conventional method for preventing penetration of machining oil and the like into a membrane switch is to bond the two sheets and the spacer together at their edges by use of an adhesive. (see Japanese Patent Application Laid-open No. 5-234459).

Another known method of forming a membrane switch omits the spacer and bonds the two sheets together except in the areas around their contact electrodes. In this technique, upper and lower flexible printed circuit (FPC) boards are coated, except for the areas corresponding to the positions of contact electrodes, with an oil-resistant resist that becomes adhesive under heat. The two FPC boards are bonded together by heat and pressure applied through a die having hollows at and around the contact electrodes. The resulting membrane switch has non-bonded areas around the contact electrodes and is bonded in the remaining areas.

In this membrane switch, the thickness of the coated resist serves as a spacer. Bonding the pair of FPC boards together with the resist also prevents penetration of machining oil and the like. There is also another known method of forming a membrane switch, wherein the upper and lower FPC boards are bonded together under heat and pressure by use of a roller instead of using a special die.

The membrane switch described in the patent document (JP 05-234459, A) mentioned above requires a spacer member, which causes a problem of increased manufacturing cost.

The method of forming a membrane switch without using a spacer member by utilizing the resist coated on the upper and lower FPC boards as a spacer and bonding the boards together under heat and pressure by use of a special die has the merit that no spacer is needed, but the use of a special die again causes a problem of increased manufacturingcost.Inthealternativemethod of forming the membrane switch by using a roller instead of using a die to bond the upper and lower FPC boards together under heat and pressure, the bonded area closely approaches the contact electrodes. A membrane switch formed by this method has problems such as a very high switch activation load and reluctance of the contact electrodes to make contact even when the switch is pressed.

### SUMMARY OF THE INVENTION

A membrane switch according to the present invention comprises a pair of FPC boards and a resist layer formed between the FPC boards, and an oil-resistant thermally adhesive resist is used in the peripheral area of the FPC boards and another type of resist that is not thermally adhesive is used in the inner area (central area) of the FPC boards. The thickness of these resists serves as a spacer between the pair of FPC boards.

According to the present invention, a membrane switch can be manufactured at low cost, since no additional spacer is required, and since the pair of FPC boards can be bonded under pressure without the use of a special die, due to the use of two types of resists between the FPC boards. Furthermore, penetration of machining oil and the like into the membrane structure can be prevented. Because the central areas of the membranes are not bonded together, on/off switching can be performed reliably with a light pressing load.

### BRIEF DESCRIPTION OF THE DRAWINGS

These and other objects and features of the present invention will be apparent from the description of the following embodiments with reference to the accompanying drawings.
In the drawings:
FIG. 1 is a top plan view of a membrane switch according to an embodiment of the present invention.
FIG. 2 is a sectional view through line A-A in FIG. 1.

### DETAILED DESCRIPTION OF THE PREFERRED EMBODIMENTS

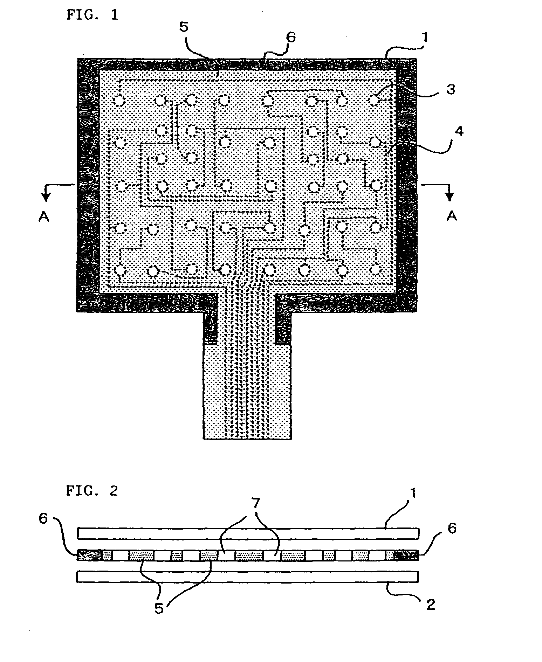

As shown in FIG. 1, contact electrodes 3 and wiring patterns 4 connected to the contact electrodes 3 are printed on the facing surfaces of an upper FPC board 1 and a lower FPC board 2. The upper and lower FPC boards 1, 2 are joined together with a resist layer between them.

As shown in FIG. 2, a first resist 5 that does not become adhesive under heat is provided in the central area between the upper and lower FPC boards 1, 2, where the contact electrodes 3 and wiring patterns 4 are printed. The first resist 5 is absent in the areas corresponding to the positions of the contact electrodes, so that these areas are left as spaces 7. The first resist 5 is also omitted from parts (not shown) forming air passages connecting the spaces 7 to the exterior of membranes.

In the peripheral areas of the upper and lower FPC boards 1,2 (the part excluding the central areas where the contact electrodes 3 and wiring patterns 4 are printed), a layer of a second resist 6 that is resistant to oil and becomes adhesive under heat is provided. The upper and lower FPC boards 1, 2 are bonded together by means of the layer of the second resist 6 provided in their peripheral areas, their facing surfaces being the surfaces on which the contact electrodes 3 and the wiring patterns 4 connected to the contact electrodes 3 are printed. Air passages similar to the air passages formed in the layer of the first resist 5 are also formed in the layer of the second resist 6, leading to the exterior of the membranes.

In this embodiment, the thickness of the first and second resists 5, 6 serves as a spacer between the upper and lower FPC boards 1, 2. Since the peripheral areas of the upper and lower FPC boards 1, 2 are thermally bonded together by means of the oil-resistant thermally adhesive second resist 6, penetration of machining oil and the like from outside the membranes into the spaces between them can be prevented. The central areas of the upper and lower FPC boards 1, 2, where the contact electrodes 3 and wiring patterns 4 are printed, are not bonded together, so on/off switching can be performed reliably with a light pressing load.

A manufacturing method for this membrane switch will be now explained.

Predetermined areas including the contact electrodes 3 (the part where the spaces 7 will be formed) and the areas where air passages will be formed, in the surfaces of the upper and/or lower FPC boards 1, 2 where the contact electrodes 3 and wiring patterns 4 are printed, are masked. And then a first resist 5 that is not thermally adhesive (that is, does not become adhesive under heat) is coated with a predetermined thickness onto the surfaces of the upper and/or lower FPC boards 1, 2 on which the contact electrodes 3 and wiring patterns 4 are printed.

Next, the masking material is removed from the peripheral areas of FPC boards 1, 2 and the areas where air passages will be formed are masked. After that, a coating of a second resist 6 that is resistant to oil and thermally adhesive (that is, becomes adhesive under heat) is applied with a predetermined thickness. Then, after all masking materials have been removed, the upper and lower FPC boards 1, 2 are joined together with the layer of first resist 5 and second resist 6 between them, and are bonded under heat and pressure by use of a press.

The second resist 6 melts under the heat and bonds the peripheral areas of the FPC boards 1, 2 together. As a result, a membrane switch is formed.

A membrane switch may be fabricated by use of a laminator instead of using a press. The roller of the laminator presses the peripheral areas of the upper and lower FPC boards 1, 2 together under heat, so they are thermally bonded together in these areas by the second resist 6.

In the present embodiment, as described above, the thickness of the resist layer provided between the upper and lower FPC boards 1, 2 forms a spacer, so that no separate spacer is required. Further, when the upper and lower FPC boards 1, 2 are bonded together by the resist, no special die is needed. Thus, a membrane switch which prevents penetration of machining oil and the like and enables on/off switching to be performed reliably is obtained.

## Claims

1. A membrane switch comprising a laminate of a pair of flexible printed circuit (FPC) boards,
wherein a type of resist that does not become adhesive under heat is provided in a central area between said laminated FPC boards, and another type of resist that is resistant to oil and becomes adhesive under heat is provided in a peripheral area outside said central area between said laminated FPC boards, the two types of resist forming a spacer between said laminated FPC boards.
